Europäisches Patentamt

European Patent Office

Office européen des brevets

(11) Publication number: **0 137 554**
**B1**

(12) **EUROPEAN PATENT SPECIFICATION**

(45) Date of publication of patent specification: **30.11.88**

(51) Int. Cl.⁴: **H 01 L 21/28, H 01 L 29/60**

(21) Application number: **84201339.3**

(22) Date of filing: **14.09.84**

(54) Method of manufacturing a semiconductor device and semiconductor device manufactured by the use of such a method.

(30) Priority: **23.09.83 NL 8303268**

(43) Date of publication of application:
**17.04.85 Bulletin 85/16**

(45) Publication of the grant of the patent:
**30.11.88 Bulletin 88/48**

(84) Designated Contracting States:
**AT DE FR GB IT NL**

(56) References cited:
**EP-A-0 099 603**
**FR-A-2 368 144**
**US-A-4 380 863**

**DIGEST INTERNATIONAL SOLID-STATE CIRCUITS CONFERENCE, 1974, pages 24-26, IEEE, New York, US; C.H. SEQUIN et al.: "Charge-coupled devices and image sensing" INTERNATIONAL ELECTRON DEVICES MEETING, 1980, Washington, D.C., 8th-10th December 1980, pages 136-139, IEEE, New York, US; M. SAKAMOTO et al.: "A new self-aligned contact technology"**

(73) Proprietor: **N.V. Philips' Gloeilampenfabrieken**
**Groenewoudseweg 1**
**NL-5621 BA Eindhoven (NL)**

(72) Inventor: **Pals, Jan Albertus**
**c/o INT. OCTROOIBUREAU B.V. Prof. Holstlaan 6**
**NL-5656 AA Eindhoven (NL)**
Inventor: **Klinkhamer, Arend Jan**
**c/o INT. OCTROOIBUREAU B.V. Prof. Holstlaan 6**
**NL-5656 AA Eindhoven (NL)**

(74) Representative: **Houbiers, Ernest Emile Marie**
**Gerlach et al**
**INTERNATIONAAL OCTROOIBUREAU B.V. Prof. Holstlaan 6**
**NL-5656 AA Eindhoven (NL)**

## Description

The invention relates to a method of manufacturing an integrated circuit comprising a semiconductor body which is provided at a surface with a multilayer wiring system comprising at least three wiring layers, which are referred to hereinafter as the first, second and third wiring layers and which are successively provided and separated from each other by insulating layers, a contact being formed between the third wiring layer and a region which forms part of the integrated circuit, the region being defined already before the first wiring layer is provided and being covered by a dielectric layer which extends above the region and beyond the edges of the region above the surface of the semiconductor body and in which a contact window is defined for the contact. The first and second wiring layers may consist, for example, of polycrystalline silicon, while a third wiring layer may consist of a pattern of Al. If desired, the polycrystalline silicon may then be further converted into a silicide by alloying it with a suitable material. The insulating layers between the wiring layers may consist of silicon oxide obtained by oxidation of the polycrystalline silicon. Suitable materials other than polycrystalline silicon, such as for example Mo or Al, may alternatively be used for the first and second wiring layers. The region which is contacted by the third wiring layer may be a diffused zone in the semiconductor body. However, in many cases the said region will consist of a part of a wiring layer which is provided before (under) the first wiring layer and is constituted, for example, by a gate electrode of an insulated gate field effect device, such as a field effect transistor or a charge-coupled device. Such a charge coupled device is disclosed e.g. in the book "Charge Coupled Devices and Systems" of Howes and Morgan, John Wiley and Sons (1980), pg. 90—95.

Due to the tendency to reduce increasingly the lateral dimensions, the step of providing the contact window in the dielectric layer, mostly an oxide layer, is very critical. When no additional measures are taken, it often occurs that due to misalignment or due to an excessively long etching treatment, not only the oxide above the region to be contacted, but also oxide beside this region is removed, as a result of which a short-circuit is produced when the Al-contact is provided. In certain cases, for example when the region to be contacted has a width of about 4 µm and the contact window also has a width of about 4 µm, for the above reason it is practically impossible to manufacture satisfactorily operating circuits with a reasonable yield without taking additional measures. In general, it is not possible to provide a contact when the region to be contacted is smaller than the sum of the smallest contact hole on the mask, the under-etching distance and the alignment tolerance.

When the region to be contacted consists of an underlying polysilicon or metal layer, the problem described above can be avoided in that a so-called etching barrier can be used in the form of a silicon nitride layer under the polysilicon or metal, the silicon nitride then extending beyond the edges of the region to be contacted. Such a method is described *inter alia* in United States Patent 4,306,353. A disadvantage of this known method is that in most of the processes a process adaptation is required. Especially, this known method will mostly require an additional nitride layer, as a result of which the process, which in any case is complicated, will comprise even more steps.

The invention has for its object to provide a method of the kind mentioned in the opening paragraph, in which undesired shortcircuits due to too large or misaligned contact windows are avoided in a manner which does not require additional processing steps. The invention is based inter alia on the recognition of the fact that the edges of the region to be contacted will always be covered when an etching barrier is manufactured in two layers which each cover only one edge of the region, whilst dimensions less than 4 µm are not required at any area of the mask. The invention is further based on the recognition of the fact that these layers can be provided simultaneously with the said first and second wiring layers.

According to the invention, a method of the kind described in the opening paragraph is characterized in that at the area of the contact to be provided a first pattern of the same material as the first wiring layer is formed simultaneously with the first wiring layer, which material can be etched selectively with respect to the dielectric layer and covers a first edge of the region, and in that a second pattern of the same material as the second wiring layer is formed simultaneously with the second wiring layer, which material can also be etched selectively with respect to the dielectric layer and which second pattern covers a second edge of the region located opposite to the first edge, after which, whilst using a mask comprising the first and second patterns, the contact window is provided in the dielectric layer. When using the first and second wiring layers at two opposite edges of the region to be contacted, a very small contact opening can be provided in the dielectric layer above the region to be contacted, while details of larger dimensions are provided in the first and second wiring layers.

A preferred embodiment, which avoids no contact being formed due to misalignment of the first and/or the second pattern (as a result of which the contact window becomes completely closed), is characterized in that beside the said contact a second contact is formed between the third wiring layer and the region, for which purpose a third pattern covering the said second edge of the region is formed in the first wiring layer simultaneously with the first pattern, whilst a fourth pattern covering the first edge of the region is formed in the second wiring layer simultaneously with the second pattern, and in that simultaneously with the said first contact window at the area of the second contact to be provided a second contact window is formed in the dielectric layer whilst using an etching mask comprising the third and fourth patterns.

The invention further relates to a semiconductor device comprising an integrated circuit manufactured at the surface of a semiconductor body, for which the said surface is provided with a multilayer wiring system comprising successively provided first, second and third wiring layers separated from each other by insulating layers, a contact being formed between the third wiring layer and a region of the integrated circuit, the region having been formed before the first wiring layer is provided and being covered by a dielectric layer which extends above the region and above the surface of the semiconductor body beyond the edges of the region and in which a contact window is formed. Such a semiconductor device according to the invention is characterized in that at the area of the contact a first pattern is formed which consists of the same material as the first wiring layer which can be etched selectively with respect to the dielectric layer and which covers a first edge of the region, and in that a second pattern is formed which consists of the same material as the second wiring layer which can also be etched selectively with respect to the dielectric layer and covers a second edge of the region, located opposite the first edge, the contact window in the dielectric layer being defined by the space between the first and the second pattern.

The invention is of particular importance for charge-coupled devices, such as two-dimensional image sensors, in which elongate narrow clock electrodes on either side of the array are connected to clock lines. It is then generally necessary that the clock electrodes of at least one clock line are contacted by an overlying Al-layer. The invention also relates to a camera provided with such a sensor.

The invention will now be described more fully with reference to a few embodiments and the accompanying diagrammatic drawings, in which:

Fig. 1 shows the circuit diagram of a charge-coupled image sensor of the F.T. type, in which the invention is used;

Fig. 2 is a longitudinal sectional view of a part of this device;

Fig. 3 is a plan view of a part of this device comprising contact regions;

Fig. 4 is a cross-section taken on the line IV—IV in Fig. 3;

Fig. 5—8 show the cross-section of Fig. 4 at a few stages in the manufacture.

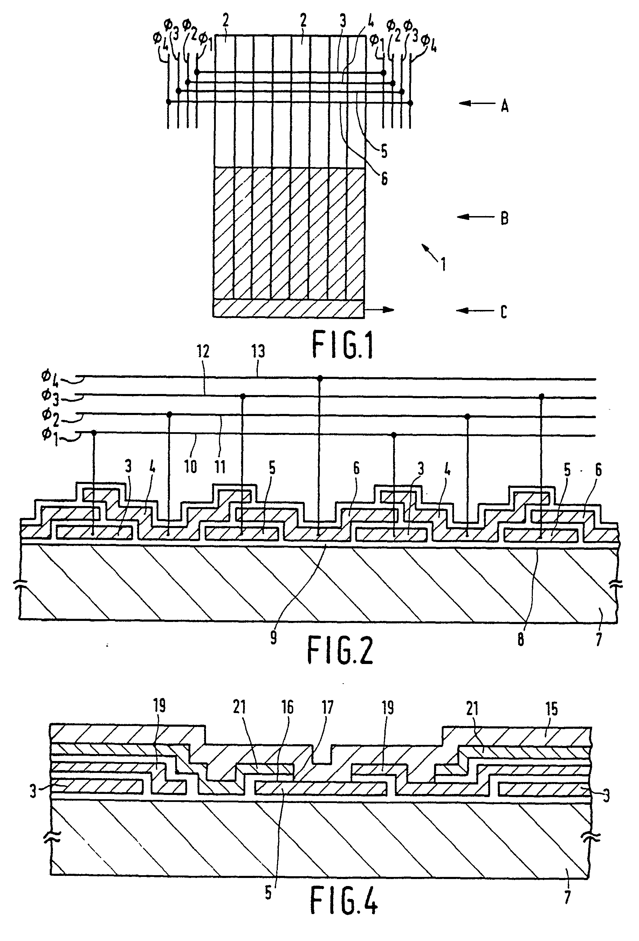

The invention will be described with reference to a CTD image sensor, the principle circuit diagram of which is shown in Fig. 1. The sensor is of the generally known frame-transfer (F.T.) type and comprises a large number of CCD channels 2 extending in the vertical or column direction. The non-shaded part A constitutes the recording part, onto which an image can be projected and in which it can then be converted into charge packets. The shaded part B constitutes the storage part, in which the mosaic of charge packets produced in A can be stored. In order to avoid a change of the stored information due to incident radiation, this part may be provided with a reflecting or adsorbing screening layer. The stored charge can be read by the horizontal register C, to which the information stored in B can be transferred linewise.

For a description in greater detail of such a sensor, reference may be made to the article "High density frame transfer image sensor", published in "Proceedings of the 14th Conf.-(1982 International) on Solid State Device", Tokyo, Japan, Journal Appl. Phys. 22, Suppl. 22-1, p. 109—112.

Fig. 1 shows four clock electrodes of the device, which, by way of example, is constructed as a four-phase device. Each of these clock electrodes 3, 4, 5 and 6 is driven via clock lines by one of the clock voltages $\phi_1$—$\phi_4$.

Due to the large number of columns 2 (generally at least a few hundreds), the clock electrodes, by which the matrix A/B is driven, can become very long. Due to the fact that the track width of these clock electrodes is also preferably very small and moréover doped polycrystalline silicon is used for the clock electrodes, high resistances may occur in the clock electrodes which are driven from one side. In order to avoid excessively high resistances in the clock electrodes, the clock electrodes on either side of the array can be contacted with clock lines. In the case in which the clock electrodes 3—6 are realized in four wiring levels, for example four layers of polycrystalline silicon (poly), each clock lines can be constituted by a rib or sleeve realized in the same poly layer as the associated phase electrode. In the case in which only three poly layers are available, this solution is no longer possible because the electrodes of at least two phases have to be realized in the same poly layer.

Fig. 2 shows a cross-section along a charge transport channel of such a three-layer poly structure. The charge transport channel 2 is defined in the semiconductor body 7 and may consist either of a surface channel or of a buried channel. The surface 8 of the body 7 is coated with a thin oxide layer 9 which constitutes the gate dielectric of the device. The electrodes 3 and 5 are both realized in the lowermost poly layer and are connected to the clock lines 10 and 12, respectively, for supplying the clock voltages $\phi_1$ and $\phi_3$, respectively. The clock electrodes 4 and 6 and the associated clock lines 11 and 13, respectively, are realized in the third poly layer (poly 3) and in the second poly layer (poly 2), respectively. The different poly levels are separated from each other by an insulating oxide layer. The clock electrodes 3, realized in poly 1, can be connected in the same manner on either side of the matrix to the clock line 11, which is likewise realized in poly 1. The clock electrodes 5 also realized in poly 1 comprise a number of loose strips which are interdigitated with the electrodes 3 and are contacted by means of a higher wiring layer.

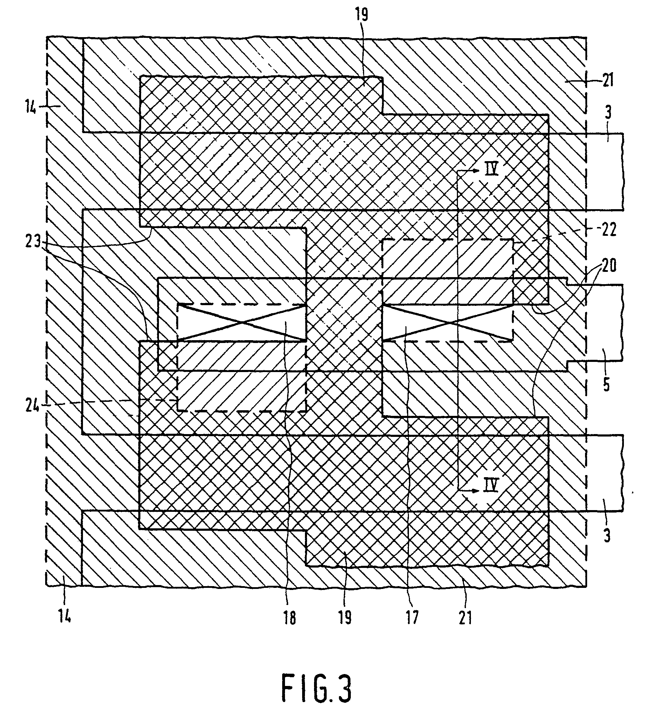

Fig. 3 is a plan view of a part of the device located at the lefthand edge of the sensor outside the active region;

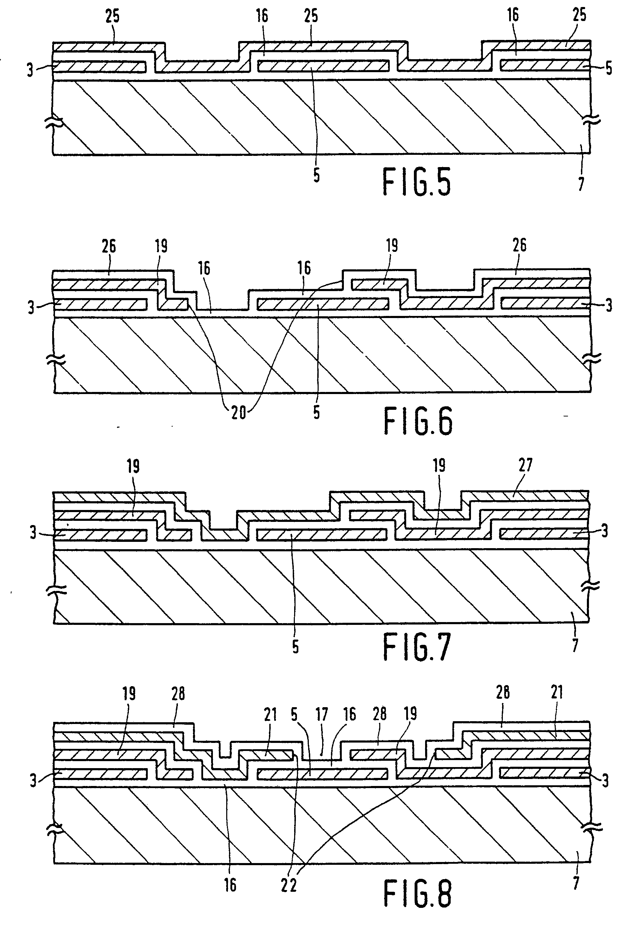

Fig. 4 is a sectional view of this part taken on the line IV—IV. In the drawing, two electrodes 3 and an intermediate electrode 5 are shown. The electrodes 4 and 6 are no longer indicated in this Figure, but should be assumed to be located with their clock lines on the righthand side outside the part shown in the drawing. The electrodes 3 are connected to each other by a clock line 10 constituted by the poly rib 14 in Fig. 3. On the righthand side of the sensor, the electrodes 3 are connected to each other by means of a similar rib.

The electrodes 5 are connected to each other by an Al-Strip 15 (Fig. 4), which interconnects the strips 5 and which can serve as a clock line 12. For the contact between the strip 5 and the Al-track 15, a contact window 17 is provided in the dielectric layer 16 which covers the electrode 5 and extends beyond the electrode 5 also above the surface 8 of the substrate 7. In Fig. 3, in which the Al-layer 15 is not shown for the sake of clarity, the contact opening 17 is marked by a cross—just line the contact opening 18 which will be referred to hereinafter.

The contact window 17 is defined by two patterns which are formed simultaneously with a first and a second overlying wiring layer, respectively. In the present embodiment in the second and in the third polycrystalline silicon layer, respectively. The first pattern 19, shaded in the drawing from the upper righthand side to the lower lefthand side, consists of a poly 2 layer having an opening 20 which is so displaced with respect to the strip 5 that an edge, i.e. the righthand edge according to Fig. 4, is covered, whereas the lefthand edge of the electrode 5 is uncovered. The second pattern 21 is formed in the third polycrystalline silicon layer and is shaded in the drawing from the upper lefthand side to the lower righthand side. The second pattern is also provided in the form of a layer which is provided with an opening 22 which is arranged so that now the lefthand edge of the electrode 5 is covered, whereas the right-hand edge of the electrode 5 is located inside the opening 22. Above the electrode 5, the patterns 19 and 21 form an opening which defines the contact window 17 in the oxide layer 16. Due to the fact that the edges of the electrode 5 are each covered by polycrystalline silicon, with respect to which the oxide layer can be etched selectively the possibility of the window 17 overlapping the edges of the electrode 5 due to excessively long etching or misalignment is practically excluded.

In order to avoid the window 17 becoming too small (or even disappearing completely) due to the fact that the pattern 19 is provided too far to the lefthand side (Fig. 4) and/or the pattern 21 is provided too far to the righthand side, a second contact window 18 (see Fig. 3) is provided beside the first contact window 17. The contact window 18 is defined by a third pattern having an opening 23 (Fig. 3) which leaves free the upper edge of the electrode 5 in Fig. 3 and by a fourth pattern having an opening 24 which leaves free the lower edge of the electrode 5. The third and fourth patterns can be provided in separate layer parts made of poly 2 and poly 3. In the present embodiment, these patterns form with the first and the second pattern, respectively, common coherent layer parts in the second and third poly layers, which are designated hereinafter by reference numerals 19 and 21, respectively. When due to misalignment the contact window 17 becomes too small or too large, the contact window 18 will become too large and too small, respectively, to practically the same extent. The overall contact surface area will therefore be practically constant and will be substantially entirely defined by the mask dimensions.

Figures 5—8, with reference to which a few processing steps in the manufacture of the device will be described, show the same cross-section of the device as Fig. 4, but now at different stages in the manufacture of the same. Fig. 5 shows the device at a stage at which the electrodes 3 and 5 are defined in poly 1 and in which a continuous poly 2 layer 25 is formed on the surface of the body, which layer is separated from the poly 1 electrodes 3 and 5 by the intermediate oxide layer 16. The oxide layer 16 may be obtained in known manner by oxidation of the poly 1 electrodes 3 and 5, but may of course also be formed by CVD techniques.

The width of the electrodes 3 and 5 is about 4 μm; the distances between the electrodes are about 3 μm.

In the usual manner, the electrodes 6 made of poly 2 are formed from the layer 25. Simultaneously with this processing step, the patterns 19 with the windows 20 and 23 are formed in the poly 2 layer 25 (Fig. 6). The width of these windows is about 4 μm. The opening 20 is so situated with respect to the electrode 5 that the righthand edge of the electrode 5 is overlapped by the pattern 19 over a distance about equal to the alignment tolerance, whereas the opposite edge is exposed. In the same manner, an opening 23 (not shown in Fig. 6), is so situated that the lefthand edge of the electrode 5 is overlapped by the pattern, whereas the righthand edge is just exposed.

After the electrodes 6 and the pattern 19 have been formed in the poly 2 layer, the exposed poly 2 can be coated with an oxide layer 26 by means of an oxidation step.

It should be noted that the pattern 19 with the windows 20 and 23 can be formed by means of a selective etching treatment, in which the poly is removed much more rapidly than the silicon oxide of the layer 16 so that, even if the opening 20 extends over the right-hand edge of the electrode 5, nevertheless no undesired shortcircuits will be produced. For this purpose, the poly 2 can be patterned, preferably by means of a wet etch of a solution of $HNO_3$ to which a very small quantity of HF is added.

In a next step (Fig. 7), a poly 3 layer 27 is formed by means of the same selective etching treatment as already described above, electrodes 4 are formed in the poly 3 layer. Simultaneously, the second pattern 21 with the opening 22 (Fig. 8) is formed from the poly 3 layer 27. The opening of the window 22 is so displaced with respect to the previously provided opening 20 that the pattern 21 overlaps the lefthand edge of the electrode 5 and leaves free the righthand edge. Simultaneously, a window 24 (not shown in Fig. 7, but shown in Fig. 3) is provided in the pattern 21, which window is displaced with respect to the window 22 and, as compared with the window 22, leaves free the other edge of the electrode 5 or overlaps this edge. The pattern 21 can be provided by the same etching technique as the pattern 19, the oxide layer 16, which covers the electrode 5, being not or substantially not attacked.

As can be seen in Fig. 8, the patterns 19 and 21 form in poly 2 and poly 3 together a mask which defines the contact window 17. Before the windows 17 and 18 are opened, the oxide covering the poly electrodes is masked by a photolacquer layer. Subsequently, the oxide 16 in the window 17 is removed in a manner known *per se*. The oxide layers 28 covering the patterns 19 and 21 (Fig. 8) are then also removed. However, if this is desired, the oxide layer 28 on the patterns 19 and 21 may be maintained at least in part in that during the etching treatment the oxide 28 is masked by a mask which need not be critically aligned with respect to the window 17. Due to the fact that the edges of the electrode 5 are masked by the patterns 19 and 21 during etching, there is substantially no risk of the oxide 16 beside the electrode 5 being also attacked, which would lead to the formation of undesired shortcircuits.

The width of the window 17 is about 2 μm (with a 4 μm wide electrode 5). The width of the window 17 is not critical. In the case in which the window 17 is smaller than 2 μm, the width of the window 18 will become larger than 2 μm. If on the contrary the window 18 is smaller than 2 μm, the width of the window 17 will be larger than 2 μm. The overall contact surface area will therefore be substantially entirely defined by a mask and will be independent of alignment tolerances.

After the windows 17 and 18 have been opened, the Al-contact layer 15 can be provided, which contacts *via* the windows 17 and 18 the electrodes 5, as a result of which the situation shown in Fig. 4 is obtained.

Finally, the device may be subjected to further usual processing steps, such as the step of forming a passivation layer and the step of providing the device in an envelope.

**Claims**

1. A method of manufacturing an integrated circuit comprising a semiconductor body (7) which is provided at a surface (8) with a multilayer wiring system comprising at least three wiring layers, which are designated hereinafter as the first (6), the second (4), and the third (15) wiring layers and which are successively provided and separated from each other by insulating layers, a contact being formed between the third wiring layer (15) and a region (5) which forms part of the integrated circuit, the region being defined already before the first wiring layer is provided and being covered by a dielectric layer (16) which extends above the region and beyond the edges of the region above the surface of the semiconductor body and in which a contact window (17) is defined for the contact, characterized in that at the area of contact to be provided a first pattern (19, 20) of the same material as the first wiring layer is formed simultaneously with the first wiring layer, which material can be etched selectively with respect to the dielectric layer and covers a first edge of the region, and in that a second pattern (21, 22) of the same material as the second wiring layer is formed simultaneously with the second wiring layer, which material can also be etched selectively with respect to the dielectric layer, this second pattern covering a second edge of the region located opposite to the first edge, after which, whilst using a mask comprising the first and second patterns, the contact window is ovided in the dielectric layer.

2. A method as claimed in claim 1, characterized in that beside the said contact a second contact (18) is formed between the third wiring layer and the region, for which a third pattern (19, 23) covering the said second edge of the region is formed in the first wiring layer simultaneously with the first pattern, whilst a fourth pattern (26, 24) covering the first edge of the region is formed in the second wiring layer simultaneously with the second pattern, and in that at the area of the second contact to be provided a second contact window (18) is provided in the dielectric layer simultaneously with the said first contact window (17), whilst using an etching mask comprising the third and fourth patterns.

3. A method as claimed in Claim 1 or 2, characterized in that the said patterns are provided in the form of strips having openings (20, 22; 23, 24) which each time cover an edge of the region (5) to be contacted and leave free the opposite edge.

4. A method as claimed in any one of the preceding Claims, characterized in that the first and second wiring layers (6, 4) are provided in the form of polycrystalline silicon.

5. A method as claimed in any one of the preceding Claims, characterized in that the region (5) to be contacted is constituted by a gate electrode of an insulated gate field effect device, more particularly a charge-coupled device.

6. A method as claimed in Claim 5 of manufacturing a charge-coupled device, characterized in that the gate electrode (5) and a number of similar gate electrodes are together arranged in a row above the channel (2) of the charge-coupled device, which gate electrodes form one phase of the charge-coupled device and are connected to each other through the said third wiring layer (15).

7. A semiconductor device comprising an integrated circuit manufactured at a surface (8) of a semiconductor body (17), for which the surface is provided with a multilayer wiring system comprising successively provided first (6), second (4) and third (15) wiring layers separated from each other by insulating layers, a contact being formed between the third wiring layer (15) and a region (15) of the integrated circuit, the region having been formed before the first wiring layer is provided and being covered by a dielectric layer (16) which extends above the region and above the surface of the semiconductor body beyond the edges of the region and in which a contact window (17) is formed characterized in that at the area of the contact a first pattern (19, 20) of the same material as the first wiring layer is formed, which material can be etched selectively with respect to the dielectric layer and covers a first edge of the region, and in that a second pattern (21, 22) of the same material as the second wiring layer is formed, which material can also be etched selectively with respect to the dielectric layer and covers a second edge of the region, located opposite to the first edge, the contact window (17) in the dielectric layer being defined by the space between the first and the second pattern.

8. A semiconductor device as claimed in Claim 7, characterized in that the region (5) of the integrated circuit is constituted by a gate electrode of an insulated gate field effect device.

9. A semiconductor device as claimed in Claim 8, characterized in that the integrated circuit comprises a charge-coupled device and in that the said gate electrode (5) forms part of a row of clock electrodes which are formed in the same wiring layer and which are connected to each other through the third wiring layer (15).

10. A semiconductor device as claimed in Claim 9, characterized in that the said clock electrodes and the said first and second wiring layers (6, 4) in which the first and second patterns are formed are provided in the form of polycrystalline silicon layers.

11. A semiconductor device as claimed in Claim 9 or 10, characterized in that the said clock electrodes (5) belong to a first phase of the charge-coupled device and in that in the same wiring layer clock electrodes (3) of a second phase are realized which are connected to each other through a rib which acts as a clock line and is also realized in the same wiring layer.

12. A semiconductor device as claimed in Claim 9, 10 or 11, characterized in that the charge-coupled device forms part of a system of adjacent parallel charge-coupled devices (2) which are provided with a common system of clock electrodes and are connected to clock lines on either side of the system of charge-coupled devices.

13. A semiconductor device as claimed in Claim 11 or 12, characterized in that the charge-coupled device is a four-phase system, whilst the clock electrodes (3, 5) of a first and a second phase with their associated clock lines in the lowermost wiring layer and the clock electrodes (6, 4) of a third and a fourth phase with their associated clock lines are provided in the same wiring layers in which the first and the second pattern, respectively, are provided.

14. A semiconductor device as claimed in Claim 12 or 13, characterized in that the device is a charge-coupled image sensor device for a solid state camera.

15. A solid state camera comprising a charge-coupled image sensor device as claimed in Claim 14.

**Patentansprüche**

1. Verfahren zur Herstellung einer integrierten Schaltung mit einem Halbleiterkörper (7), der auf einer Oberfläche (8) mit einem Mehrschichtverdrahtungssystem mit wenigstens drei durch isolierende Schichten voneinander getrennten Verdrahtungsschichten versehen wird, die i.folg. als erste (6), zweite (4) und dritte (15) Verdrahtungsschicht bezeichnet und nacheinander angebracht werden, wobei zwischen der dritten Verdrahtungsschicht (15) und einem einen Teil der integrierten Schaltung bildenden Gebiet (5) ein Kontakt gebildet wird, wobei dieses Gebiet bereits vor dem Anbringen der ersten Verdrahtungsschicht definiert ist und mit einer dielektrischen Schicht (16) bedeckt ist, die sich über dem Gebiet und bis jenseits der Ränder des Gebietes über der Oberfläche des Halbleiterkörpers erstreckt und in dem zwecks des Kontaktes ein Kontaktfenster (17) definiert wird, dadurch gekennzeichnet, dass an der Stelle des anzubringenden Kontaktes gleichzeitig mit dem Anbringen der ersten Verdrahtungsschicht ein erstes Muster (19, 20) aus demselben Material wie das der ersten Verdrahtungsschicht gebildet wird, wobei dieses Material gegenüber der dielektrischen Schicht selektiv ätzbar ist und einen ersten Rand des Gebietes bedeckt und dass gleichzeitig mit dem Anbringen der zweiten Verdrahtungsschicht ein zweites Muster (21, 22) aus demselben gegenüber der dielektrischen Schicht ebenfalls selektiv ätzbaren Material gebildet wird, wobei dieses zweite Muster einen zweiten gegenüber dem ersten Rand liegenden Rand des Gebietes bedeckt, wonach unter Verwendung einer das erste und zweite Muster umfassenden Maske das Kontaktfenster in der dielektrischen Schicht angebracht wird.

2. Verfahren nach Anspruch 1, dadurch gekennzeichnet, dass nebst dem genannten Kontakt ein zweiter Kontakt (18) zwischen der dritten Verdrahtungsschicht und dem Gebiet gebildet wird, wobei zu diesem Zweck gleichzeitig mit dem ersten Muster ein drittes Muster (19, 23) in der ersten Verdrahtungsschicht gebildet wird, das den genannten zweiten Rand des Gebietes bedeckt und wobei gleichzeitig mit dem zweiten Muster ein viertes Muster (26, 24) in der zweiten Verdrahtungsschicht gebildet wird, das den ersten Rand des Gebietes bedeckt und wobei gleichzeitig mit dem Anbringen des genannten ersten Kontaktfensters (17) an der Stelle des anzubringenden zweiten Kontaktes ein zweites Kontaktfenster (18) in der dielektrischen Schicht angebracht wird und zwar unter Verwendung einer Ätzmaske, die das dritte und das vierte Muster aufweist.

3. Verfahren nach Anspruch 1 oder 2, dadurch gekennzeichnet, dass die genannten Muster in Form von Streifen mit Öffnungen (20, 22; 23, 24) vorgesehen sind, die jeweils einen Rand des zu kontaktierenden Gebietes (5) bedecken und den gegenüberliegenden Rand frei lassen.

4. Verfahren nach einem der vorstehenden Ansprüche, dadurch gekennzeichnet, dass die erste und zweite Verdrahtungsschicht (6, 4) in Form von polykristallinem Silizium vorgesehen sind.

5. Verfahren nach einem der vorstehenden Ansprüche dadurch gekennzeichnet, dass das zu kontaktierende Gebiet (5) durch eine Gate-Elektrode einer Feldeffektanordnung mit isolierter Gate-Elektrode, insbesondere durch eine ladungsgekoppelten Anordnung gebildet wird.

6. Verfahren nach Anspruch 5 zum Herstellen einer ladungsgekoppelten Anordnung, dadurch gekennzeichnet, dass die Gate-Elektrode (5) und eine Anzahl ähnlicher Gate-Elektroden zusammen in einer Reihe über dem Kanal (2) der ladungsgekoppelten Anordnung vorgesehen sind, wobei diese Gate-Elektroden eine Phase der ladungsgekoppelten Anordnung bilden und mittels der genannten dritten Verdrahtungsschicht (15) miteinander verbunden sind.

7. Halbleiteranordnung mit einer integrierten Schaltung auf einer Oberfläche (8) eines Halbleiterkörpers (17), wobei zu diesem Zweck die Oberfläche mit einem Mehrschichtverdrahtungssystem versehen ist, das nacheinander angebracht und durch Isolierschichten voneinander getrennt, eine erste (6), eine zweite (4) und eine dritte (15) Verdrahtungsschicht aufweist, wobei zwischen der dritten Verdrahtungsschicht (15) und einem Gebiet (15) der integrierten Schaltung, das vor dem Anbringen der ersten Verdrahtungsschicht gebildet und mit einer dielektrischen Schicht (16) bedeckt ist, die sich über dem Gebiet und über der Oberfläche des Halbleiterkörpers bis jenseits der Ränder des Gebietes erstreckt und in dem ein Kontaktfenster (17) gebildet ist, ein Kontakt gebildet ist, dadurch gekennzeichnet, dass an der Stelle des Kontaktes ein erstes Muster (19, 20) gebildet ist aus demselben, gegenüber der dielektrischen Schicht selektiv ätzbaren Material wie das der ersten Verdrahtungsschicht und dass einen ersten Rand des Gebietes bedeckt und dass ein zweites Muster (21, 22) gebildet ist aus demselben Material wie das der zweiten Verdrahtungsschicht, und das ebenfalls gegenüber der dielektrischen Schicht selektiv ätzbar ist und einen zweiten Rand des Gebietes bedeckt, der gegenüber dem ersten Rand liegt, wobei das Kontaktfenster (17) in der dielektrischen Schicht durch den Raum zwischen dem ersten und dem zweiten Muster definiert ist.

8. Halbleiteranordnung nach Anspruch 7, dadurch gekennzeichnet, dass das Gebiet (5) der integrierten Schaltung durch eine Gate-Elektrode einer Feldeffektanordnung mit isolierter Gate-Elektrode gebildet wird.

9. Halbleiteranordnung nach Anspruch 6, dadurch gekennzeichnet, dass die integrierte Schaltung eine ladungsgekoppelte Anordnung aufweist und dass die genannte Gate-Elektrode (5) einen Teil einer Reihe von Taktimpulselektroden bildet, die in derselben Verdrahtungsschicht gebildet sind und die mittels der dritten Verdrahtungsschicht (15) miteinander verbunden sind.

10. Halbleiteranordnung nach Anspruch 9, dadurch gekennzeichnet, dass die genannten Taktimpulselektroden und die genannte ersten und zweite Verdrahtungsschicht (6, 4), in denen das erste und zweite Muster gebildet sind, in Form von polykristallinen Siliziumschichten angebracht sind.

11. Halbleiteranordnung nach Anspruch 9 oder 10, dadurch gekennzeichnet, dass die genannten Taktimpulselektroden (5) einer ersten Phase der ladungsgekoppelten Anordnung zugeordnet sind und dass in derselben Verdrahtungsschicht Taktimpulselektroden (3) einer zweiten Phase verwirklicht sind, die mittels eines als Taktimpulsleitung wirksamen Rückens miteinander verbunden sind und ebenfalls in derselben Verdrahtungsschicht verwirklicht ist.

12. Halbleiteranordnung nach Anspruch 9, 10 oder 11, dadurch gekennzeichnet, dass die ladungsgekoppelt Anordnung einen Teil eines Systems nebeneinander liegender paralleler ladungsgekoppelter Anordnungen (2) bildet, die mit einem gemeinsamen System von Taktimpulselektroden versehen und auf beiden Seiten des Systems ladungsgekoppelter Anordnungen mit Taktimpulsleitungen verbunden sind.

13. Halbleiteranordnung nach Anspruch 11 oder 12, dadurch gekennzeichnet, dass die ladungsgekoppelte Anordnung ein Vier-Phasensystem ist, wobei die Taktimpulselektroden (3, 5) einer ersten und einer zweiten Phase mit den zugeordneten Taktimpulsleitungen in der untersten Verdrahtungsschicht und die Taktimpulselektroden (6, 4) einer dritten und einer vierten Phase mit den zugeordneten Taktimpulsleitungen in denselben Verdrahtungsschichten angebracht sind, in denen das erste bzw. das zweite Muster vorgesehen sind.

14. Halbleiteranordnung nach Anspruch 12 oder 13, dadurch gekennzeichnet, dass die Anordnung eine ladungsgekoppelte Bildsensoranordnung für eine Feststoffkamera ist.

15. Feststoffkamera mit einer ladungsgekoppelten Sensoranordnung nach Anspruch 14.

**Revendications**

1. Procédé de fabrication d'un circuit intégré comportant un corps semiconducteur (7) muni, sur une surface (8), d'un système de câblage à plusieurs couches comportant au moins trois couches de câblage appelées ci-après première (6), deuxième (4) et troisième (15) couches de câblage et qui sont réalisées successivement tout en étant séparées par des couches isolantes, un contact étant formé entre la troisième couche de câblage (15) et une région (5) faisant partie du circuit intégré, région qui a déjà été définie avant la formation de la première couche de câblage et qui est recouverte d'une couche diélectrique (16) s'étendant au-dessus de la région ainsi que, au-delà des bords de la région, au-dessus de la surface du corps semiconducteur et dans laquelle est définie une fenêtre de contact (17) pour la mise en contact, caractérisé en ce qu'à l'endroit du contact devant être réalisé, on forme simultanément avec la première couche de câblage une première configuration (19, 20) du même matériau que la première couche de câblage, matériau qui peut être attaqué de façon sélective par rapport à la couche diélectrique et qui recouvre un premier bord de la région, et en ce qu'on forme simultanément avec la deuxième couche de câblage une deuxième configuration (21, 22) du même matériau que la deuxième couche de câblage, matériau qui peut également être attaqué de façon sélective par rapport à la couche diélectrique, ladite deuxième configuration recouvrant un deuxième bord de la région situé à l'opposé du premier bord, après quoi, au moyen d'un masque comportant les première et deuxième configurations, on pratique la fenêtre de contact dans la couche diélectrique.

2. Procédé de fabrication selon la revendication 1, caractérisé en ce qu'à côté dudit contact on forme un second contact (18) entre la troisième couche de câblage et la région, but dans lequel, simultanément avec la formation de la première configuration, on forme dans la première couche de câblage une troisième configuration (19, 23) recouvrant ledit deuxième bord de la région, alors que, simultanément avec la formation de la deuxième configuration, on forme dans la deuxième couche de câblage une quatrième configuration (26, 24) recouvrant le premier bord de la région, et en ce que, simultanément avec la formation de ladite première fenêtre de contact (17), on forme dans la couche diélectrique une seconde fenêtre de contact (18) à l'endroit du second contact en utilisant un masque d'attaque comportant les troisième et quatrième nfigurations.

3. Procédé de fabrication selon la revendication 1 ou 2, caractérisé en ce qu'on réalise lesdites configurations sous la forme de bandes présentant des ouvertures (20, 22; 23, 24) qui, chacune, recouvrent un bord de la région (5) devant être mise en contact et laissent à découvert le bord opposé.

4. Procédé selon l'une quelconque des revendications précédentes, caractérisé en ce qu'on réalise la première et deuxième couches de câblage (6, 4) sous la forme de silicium polycristallin.

5. Procédé selon l'une quelconque des revendications précédentes, caractérisé en ce que la région (5) devant être mise en contact est constituée par une électrode de grille d'un dispositif à effet de champ à grille isolée, et notamment d'un dispositif à couplage de charges.

6. Procédé selon la revendication 5, de fabrication d'un dispositif à couplage de charges, caractérisé en ce qu'on forme l'électrode de grille (5) conjointement avec une pluralité d'électrodes de grille analogues sur une ligne au-dessus du canal (2) du dispositif à couplage de charges, électrodes de grille qui forment l'une des phases du dispositif à couplage de charges et qui sont reliées entre elles par ladite troisième couche de câblage (15).

7. Dispositif semiconducteur comportant un circuit intégré réalisé sur une surface (8) d'un corps semiconducteur (7), but dans lequel cette surface est munie d'un système de câblage à plusieurs couches comportant successivement des première (6), deuxième (4) et troisième (15) couches de câblage séparées l'une de l'autre par des couches isolantes, un contact étant formé entre la troisième couche de câblage (15) et une région (5) du circuit intégré, région qui a été formée avant la première couche de câblage et qui est recouverte d'une couche diélectrique (16) s'étendant au-dessus de la région ainsi que, au-delà des bords de la région, au-dessus de la surface du corps semiconducteur et dans laquelle est pratiquée une fenêtre de contact (17), caractérisé en ce qu'à l'endroit du contact, est formée une première configuration (19, 20) constituée par le même matériau que la première couche de câblage, matériau qui peut être attaqué de façon sélective par rapport à la couche diélectrique et qui recouvre un premier bord de la région, et en ce qu'il est prévu une deuxième configuration (21, 22) constituée par le même matériau que la deuxième couche de câblage, matériau qui peut également être attaqué de façon sélective par rapport à la couche diélectrique et qui recouvre un deuxième bord de la région situé à l'opposé du premier bord, la fenêtre de contact (17) dans la couche diélectrique étant définie par l'espace séparant les première et deuxième nfigurations.

8. Dispositif semiconducteur selon la revendication 7, caractérisé en ce que la région (5) du circuit intégré est constituée par une électrode de grille d'un dispositif à effet de champ à grille isolée.

9. Dispositif semiconducteur selon la revendication 8, caractérisé en ce que le circuit intégré comporte un dispositif à couplage de charges et en ce que ladite électrode de grille (5) fait partie d'un alignement d'électrodes d'horloge formées dans la même couche de câblage et reliées entre elles par la troisième couche de câblage (15).

10. Dispositif semiconducteur selon la revendication 9, caractérisé en ce que lesdites électrodes d'horloge et lesdites première et deuxième couches de câblage (6, 4) dans lesquelles sont formées les première et deuxième configurations, sont réalisées sous la forme de couches de silicium polycristallin.

11. Dispositif semiconducteur selon la revendication 9 ou 10, caractérisé en ce que lesdites électrodes d'horloge (5) appartiennent à une première phase du dispositif à couplage de charges et en ce que, dans la même couche de câblage, sont réalisées des électrodes d'horloge (3) d'une deuxième phase, reliées entre elles par une nervure servant de ligne d'horloge et également réalisée dans la même couche de câblage.

12. Dispositif semiconducteur selon la revendication 9, 10 ou 11, caractérisé en ce que le dispositif à couplage de charges fait partie d'un système de dispositifs à couplage de charges parallèles voisins (2) munis d'un système commun d'électrodes d'horloge et reliés à des lignes d'horloges des deux côtés du système de dispositifs à couplage de charges.

13. Dispositif semiconducteur selon la revendication 11 ou 12, caractérisé en ce que le dispositif à couplage de charges est un système à quatre phases dans lequel les électrodes d'horloge (3, 5) d'une première et d'une deuxième phase avec leur lignes d'horloge associées sont prévues dans la couche de câblage inférieure et les électrodes d'horloge (6, 4) d'une troisième et d'une quatrième phase avec leurs lignes d'horloge associées sont prévues dans les mêmes couches de câblage que celles où sont réalisées respectivement les première et deuxième configurations.

14. Dispositif semiconducteur selon la revendication 12 ou 13, caractérisé en ce qu'il est un dispositif capteur d'images couplage de charges destiné à une caméra à l'état solide.

15. Caméra à l'état solide comportant un dispositif capteur d'images à couplage de charges selon la revendication 14.

EP 0 137 554 B1

1/3

FIG.1

FIG.2

FIG.4

1

FIG.3

3/3

FIG.5

FIG.6

FIG.7

FIG.8